# EUROPEAN PATENT APPLICATION

(11) **EP 2 096 190 A1**
(43) Date of publication of application: **02.09.2009**
(21) Application number: 08152075.1
(22) Date of filing: 28.02.2008
(51) Int. Cl.: C23C 14/56, H01J 37/34

(54) **Coating apparatus for coating a web**

(71) Applicant: Applied Materials, Inc., Santa Clara, CA 95054 (US)
(72) Inventor: Hein, Stefan, 63825 Blankenbach (DE); Sauer, Peter, 36381 Schlüchtern (DE); Herzog, Jens, 63500 Seligenstadt (DE)
(74) Representative: Zimmermann & Partner

(57) **Abstract**

A coating apparatus for coating a web (110) with a coating material is provided. The web is guided by an endless belt (130) that contacts the web. By contacting the web an energy transfer from the endless belt to the web is possible. This can be an exchange of thermal energy or the like. For exchanging electrical energy, the endless belt is connected to a power supply (150). Therefore, the web can be electrically charged or discharged depending on the desired result. Furthermore, an arrangement is provided having a plurality of coating apparatuses connected to increase the length of contact between the endless belt and the web as e.g. necessary for producing solar cells.

## Description

### FIELD OF THE INVENTION

The present invention relates to thin-film forming apparatuses and methods, in particular for coating of flexible TFT-display, flexible transistor electronics, such as Si-based electronics. In particular, it relates to devices and methods for coating a web. Even more particular, it relates to devices and methods for coating a web for the production of thin-film solar cells.

### BACKGROUND OF THE INVENTION

It is known to provide rollers and drums that allow guiding the web during coating. The web moves over the drum with its uncoated side while it is coated on the other side. Additional rollers are provided for guiding the web between coating steps.

However, the use of drums for backing the web during coating reveals several problems. In many applications, in particular in thin-film solar cell production applications, typical coating lengths are several metres. In order to guide the web on large distances, as for instance 10 m, huge drums have to be provided for guiding and controlling the web during coating. As a result, the space requirements of the coating apparatuses reach a high level of inefficiency. Further, it has to be considered that the direct contact of a web with rollers on the side of the web that is already coated may harm the coating. Therefore, guiding the web after it has been coated requires complex guiding paths that avoid a direct contact between coated side and guiding devices such as rollers.

In addition, in apparatuses and methods for coating a web such as e.g. in the production of thin-film solar cells it is necessary to guide the web while simultaneously controlling the temperature of the web to be coated as well as the electrical charging. It has been found out that controlling both the temperature and the electrical charge can be essential for the result and the success of the coating process. For instance, undesired and/or irregular coating patterns or a spoiled inner structure of the layers deposited may be a result of a missing thermal and electrical control.

### SUMMARY OF THE INVENTION

In view of the above, a coating apparatus for evaporating a coating material on a web is provided. The coating apparatus includes a coating process source and an endless belt for guiding and contacting the web, the endless belt being equipped with a temperature control means for keeping the web at a predetermined temperature and a contact for contacting the endless belt with a power supply. The endless belt is at least partly conductive.

According to other embodiments described herein, an arrangement is provided being a combination of at least two coating apparatuses.

According to other embodiments described herein a method for evaporating a coating material on a web is provided, the method including guiding the web; contacting the web thermally; contacting the web electrically; and coating the web.

According to other embodiments described herein, a method for evaporating a coating material on a web is provided comprising guiding the web with the aid of an endless belt, which is linked to a power supply, contacting the web thermally as well as electrically, and coating the web.

Further aspects, details, advantages and features are apparent from the dependent claims, the description and the accompanying drawings.

Embodiments are also directed to apparatuses for carrying out each of the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Figure 1a shows a schematic view of an coating apparatus according to embodiments described herein.

Figure 1b shows a schematic view of an coating apparatus according to further embodiments described herein.

Figure 1c shows a schematic view of an coating apparatus according to further embodiments described herein.

Figure 2a shows a schematic view of a part of a guiding device of the coating apparatus according to embodiments described herein.

Figure 2b shows a schematic view of a part of a guiding device of the coating apparatus according to further embodiments described herein.

Figure 2c shows a schematic view of a part of a guiding device of the coating apparatus according to further embodiments described herein.

Figure 3a shows a schematic view of an arrangement having a plurality of coating apparatuses.

Figure 3b shows a schematic view of another arrangement having a plurality of coating apparatuses.

Figure 3c shows a schematic view of an arrangement having a plurality of coating apparatuses.

### DETAILED DESCRIPTION OF THE DRAWINGS

Within the following description of the drawings, the same reference numbers refer to the same components. Generally, only the differences with respect to the individual embodiments are described.

The process of coating a web with a coating material as described herein refers typically to thin-film applications. The coating apparatus includes a coating process source. In general, a coating process source is understood as a unit capable of providing coating material in such a way that a web can be coated with the coating material. The coating material can be provided, for instance, by way of evaporating the coating material, by way of sputtering the coating material, by a PECVD process, a CVD process, MOCVD, PVD or the like. According to some embodiments, the process source can be an evaporator. According to other embodiments, the process source can be a sputtering process source.

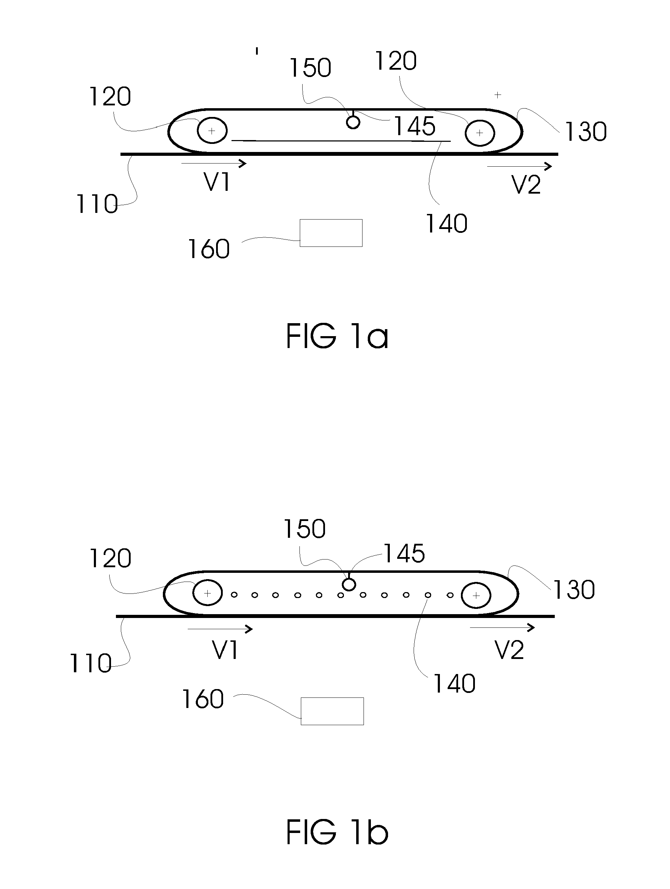

Figure 1a is a schematic cross-sectional view illustrating embodiments of an coating apparatus. As indicated by the arrows denoted V1 and V2, the web 110 can move from the left side of the drawing to the right side. According to other embodiments, the web could also move from the right side to the left side. The web 110 is guided by the endless belt 130. The endless belt 130, in turn, is guided by endless belt guiding devices 120. The endless belt guiding devices, which shall also be named "guiding devices" herein, can be rollers, reels, rolls, cylinders, or the like. Typically, the endless belt is guided by at least two guiding devices. According to other embodiments, the endless belt is guided by three or more guiding devices. Typically, the endless belt provides for a flat and non-curved surface for backing the web. The typical length of the surface with respect to the moving direction of the web is larger than 2 m and/or smaller than 15 m, more typically larger than 5 m and smaller than 12 m.

The term "web" as used herein can typically be **characterized in that** it is bendable. The term "web" may be synonymously used to the term "strip". For instance, the web as described in the embodiments herein may be a foil.

The endless belt is conductive or at least partly conductive. It may be formed from metal or any other material capable to conduct electrical charging. Further, it may comprise several different materials with at least one material being conductive. According to yet further embodiments, the endless belt comprises several layers of conductive and/or non-conductive material with at least one layer being conductive. The endless belt comprises a surface for contacting the web. This surface shall be called "contacting surface". Typical materials can be aluminum, stainless steel, or the like.

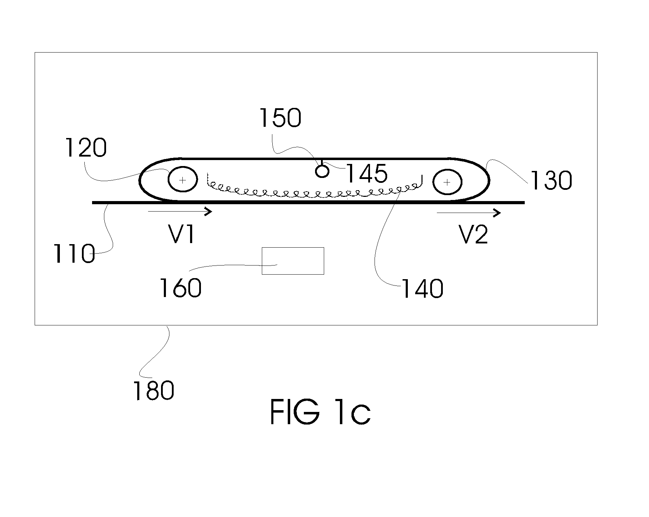

According to embodiments described herein, the coating apparatus may be placed in a vacuum atmosphere. This is exemplarily shown in the embodiment of Fig. 1c. The term "vacuum" as described herein refers typically to a pressure of the order of magnitude 1 mbar or less, more typically of 10⁻³ mbar or less. The vacuum may be generated with vacuum-pumps that generate the vacuum and hold up the vacuum in the vacuum chamber during the coating process. The vacuum chamber 180 shown in figure 1c could also be applied according to other embodiments described herein, in particular in the embodiments being schematically shown in figure 1a and figure 1b.

Particularly in chemical vapor deposition (CVD) applications that are, for instance, applied in the production of thin-film solar cell production, it is necessary to introduce hydrogen into the coating chamber. For instance, in a typical CVD application, silane and hydrogen are introduced into the coating chamber, in which the coating apparatus is located. Moreover, argon is particularly typical in sputtering processes such as are used for producing the transparent and conductive oxide (TCO) layer or the back contact (BC) of a thin-film solar cell. Hence, according to typical embodiments described herein, the coating apparatus comprises an inlet for introducing process gas.

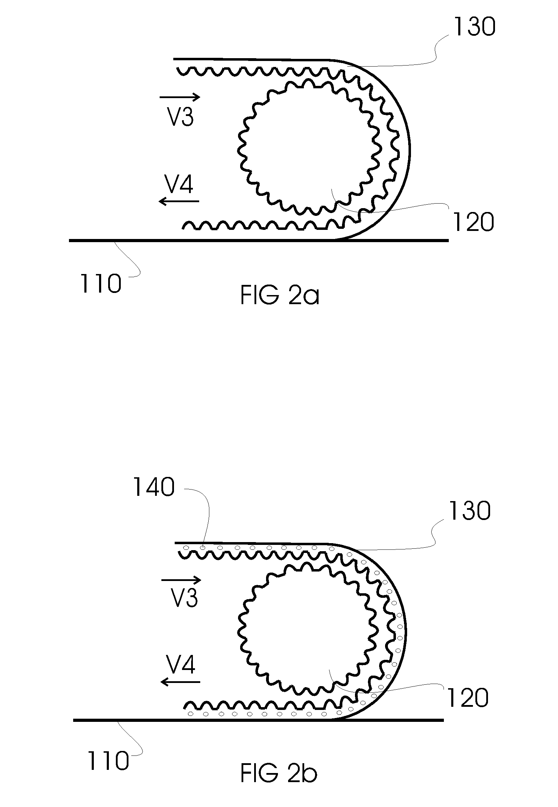

The web 110 is guided by the endless belt 130 and contacts it along a certain length of the endless belt 130. The term "endless belt" should be understood as a moving device with a never-ending closed surface. The endless belt may be a bendable and/or elastic strip, a multitude of small connected plates, a chain or the like. As described previously, the contacting surface of the endless belt may additionally be coated. The length of the endless belt is dependent on the construction of the coating apparatus. As can be seen in figure 2a, the endless belt 130 moves in different directions dependent on the position of the belt. For instance, the moving direction of the endless belt 130 before and after the turn-around at the guiding devices is indicated in figure 2a by the arrows V3 and V4.

Furthermore, the coating apparatus comprises a process source 160. The process source may be a sputter-etcher. The process source may also be an evaporator such as a crucible for coating material or the like. The crucible may be heatable and may be adapted for receiving and evaporating the coating material. The process source may be made of metallic boride, a metallic nitride such as titanium nitride, a metallic carbide, a non-metallic boride, a non-metallic nitride, a non-metallic carbide, nitrides, borides, graphite, B₄C, SiC, TiB₂, a combination of TiB₂ and A1N, a combination of TiB₂ and BN, or a combination of TiB₂, BN and A1N.

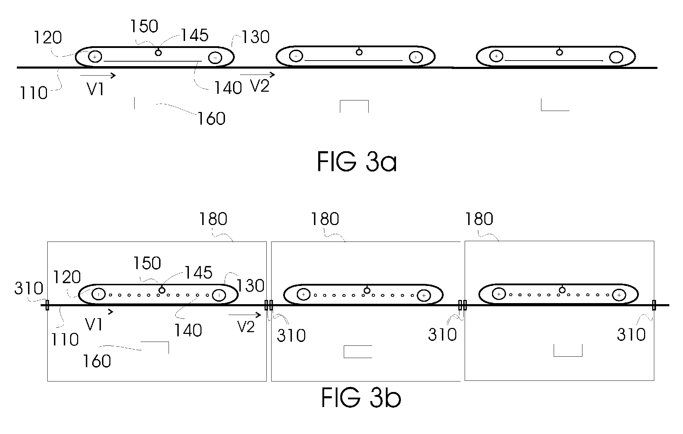

According to embodiments described herein, the web is coated at one side of the web while it is synchronously guided on the other side of the web. This is illustrated in figures 1a-1c and 3a-3c. The endless belt backs the web at its rear side while it is coated on the other side of the web. According to embodiments of the coating apparatus, the process source is arranged opposite to the endless belt. Typically, if there would not be a web between the process source and the endless belt, the process source would coat the endless belt.

Typically, the web 110 is led between the endless belt guiding device 120 with the endless belt 130 and the process source 160. Thereby one side of the web can be coated with coating material from the process source 160. The other side is in contact with the endless belt 130.

When contacting the endless belt 130, a temperature exchange can be performed between the endless belt 130 and the web 110. The temperature of the endless belt is kept at a predetermined value by a temperature control means 140. As shown in figure 1a, the temperature control means can be channels filled with fluid. Typically, the channels are placed close to the side of the web that is contacting the endless belt. The term "close" in this context refers to a distance that is typically less than 5 cm and more typically less than 2 cm. The channels may be distributed such that they are located in a constant distance to each other in order to achieve a regular temperature distribution.

If an irregular distribution of the temperature is desirable, the channels of the temperature control means may be in a distance to each other that is not constant. "Irregular" should be understood in the way that sections or parts of the web have another temperature as the rest of the web. For instance, it could be desired that the temperature of the arriving web is slowly amended while the web - driven by the movement of the endless belt - approaches the center of the endless belt. In order to do so, the distance of the channels of the temperature control means could be smaller in the center region of the endless belt with respect to its moving direction than the distance of the channels in the regions close to the guiding devices.

The channels may have a circular cross-sectional profile, an elliptic cross-sectional profile or a cross-sectional profile with any other form. The fluid in the temperature control means can be thermo-conducting. The fluid has typically a high thermal coefficient. The endless belt is in tight contact to the web 110 and can conduct its thermal energy to the web 110. In the event that the web is cooled by the endless belt, the endless belt 130 draws off the thermal energy from the web 110. For instance, the thermo-conducting fluid of the temperature control means 140 can absorb the thermal energy of the endless belt 130. Thereby, a temperature exchange is performed.

According to embodiments described herein, the heat transfer is possible in two ways: either the fluid has a lower temperature than the web 110 or the fluid has a higher temperature than the web 110. In the first case, the web 110 will be cooled, in the second case, the web is heated. Hence, a plurality of processes can take place as the temperature of the web 110 is variable and controllable in a wide range. Cooling and heating may be performed by providing and operating a peltier-element being in direct or indirect contact with the fluid. The temperature can be adjusted by applying the peltier-element to a predetermined voltage. Alternatively, heating may be performed by providing a heating wire in contact with the fluid.

Depending on whether the web is heated or cooled, the streaming fluid carries the thermal energy away from the web or to the web. Fresh fluid streams to the place where the heat exchange takes place. According to embodiments described herein, the channels for the fluid may be arranged in any angle to the moving direction of the web V1 and V2. The channels for the fluid may be arranged in a right angle to the moving direction V1 and V2 as exemplarily shown in figure 1b. The temperature control means 140 in figure 1b comprises several fluid-filled channels that are arranged at right angle to the moving direction V1 and V2.

According to yet another embodiment, the temperature control means may be a helix as shown in figure 1c. The helix could be filled with a thermo conducting fluid. The form of the helix increases the area at which heat transfer can take place. The effects will be the same as described above with respect to figure 1a. Another possibility is a helix made from an electrical conducting material such as steel or the like with the helix acting as heating wire. By applying the helix to a predetermined potential difference, the temperature of the helix will increase and with the effects described above, the temperature of the web 110 will increase, too.

According to embodiments described herein, the endless belt 130 contains electrical conductive or non-conductive material or materials. The endless belt may be made of but one material and/or the endless belt may comprise at least two layers of material either from the same material or from different materials. The endless belt is, according to embodiments, connected to a power supply. Therefore, the contact between the endless belt 130 and the web 110 can be used to transfer electrical energy. The endless belt comprises a contact 145 that is adapted to be linked to an electrical power supply. An electrical power supply 150, as shown in figure 1a, 1b and 1c, is arranged and so that a current carrying electrical charge may flow from the endless belt 130 to the web 110. This may influence the characteristics of the coating process. The quality of the coated thin film can be improved as well as its characteristics concerning adhesion and homogeneity. The electrical charging may also be used as a sort of activating potential for diffusion of the coating material on the surface of the coated material.

The endless belt 130 may be used as a counter electrode. The use as a counter electrode may be achieved by a connection of the endless belt with a power source. To apply electrical charge to the endless belt and thus to the web may permit or facilitate the deposition process. For instance, in some embodiments the deposition may be enhanced when the endless belt, acting as electrode, is held at a predetermined charging level.

Further, as the web may be electrically charged due to the coating process, the electrical charging of the web can cause unwanted effects that can influence the result of the coating process. This may negatively influence the quality of the coating film. Thus, the desired functionality of the thin film may be affected. Therefore a counter electrode is useful to avoid these sorts of problems. The electrical charging of the web, generated by the coating process, can be drained off by the electrical contact of the web with the endless belt. A current may flow from the charged web to the counter electrode.

Figure 2a shows an embodiment of an endless belt guiding device 120. The endless belt 130 is guided by the endless belt guiding device 120 where it is turned around. Typically, the guiding device 120 has a cylindrical cross-section. The endless belt guiding device 120 may be driven by a motor. The motor may have a rotatable shaft. According to embodiments, the endless belt guiding device may also be driven by the endless belt by using the movement of the web.

In general, different velocities for certain sections or parts may be useful when, for instance, a different temperature of the sections of a web is desirable. Different velocities can be achieved by driving the endless belt guiding device at a varying velocity. By guiding certain sections of a web faster or more slowly by the endless belt, the time for exchanging temperature varies and thus, the temperature of the different section varies, too. The same effect can be useful for the electrical contacting. Therefore, different thicknesses or different layers of the coating material are possible.

According to embodiments described herein, the temperature control means can be located in the endless belt itself. The belt can contain a plurality of fluid-filled channels for the heat transfer. Typically, the belt is in contact with the web only on one side of the guiding device, in the following denoted as "contact side", whereas the side opposite to the contact side is denoted "opposite side". In figure 2b, the belt is in contact with the web 110 on the contact side of the endless belt. The temperature exchange between the web and the belt takes place as described above and the endless belt is turned around according to the arrows V3 and V4 indicating the movement direction of the endless belt. "Turning around" means changing the moving direction of the endless belt. According to typical embodiments, the moving direction is amended at 180°. However, in particular in coating apparatuses having three or more guiding devices, the change of moving direction can be smaller such as between 90° and 180°, more typically between 115° and 135°.

In operation of the process source, if there was no cooling by use of the temperature control means, the contact side of the endless belt would be warmer than the opposite side due to the coating process generating heat. In general, the temperature control means is arranged in contact to the contact side such as close to the contact side. It is further possible to arrange the temperature control means close to the opposite side.

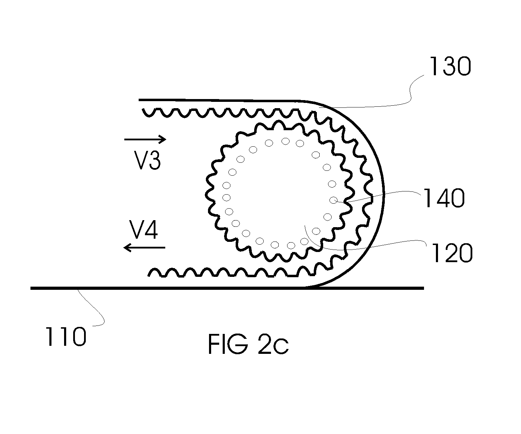

According to embodiments described herein, the temperature control means may be located in the endless belt guiding devices itself. The temperature control means 140 located in the guiding devices 120 may comprise fluid-filled channels to perform the heat exchange. This is shown in the embodiment of figure 2c. During the contact of the guiding devices with the endless belt the endless belt is brought to the desired temperature. Afterwards, during the contact of the endless belt with the web, the web is brought to the desired temperature.

In typical embodiments, the radius of the endless belt guiding devices lies between 5cm and 1m, more typically between 10 cm and 70 cm, even more typically between 15 cm and 30 cm, for example 20 to 30 cm.

The endless belt guiding device 120 can be rotatable and is temporarily in contact to a part or a section of the endless belt 130. This part or section is variable and changes with the movement of the endless belt 130. The contact between endless belt and guidinig device may be via a gearwheel from a worm gear, a pinion gear, a plate gear or the like.

According to embodiments described herein, a plurality of coating apparatuses according to embodiments described herein can be arranged in a row. In Figure 3a, several coating apparatuses each having a temperature control means 140 are arranged in line. The arrangement is not limited so that two, three or more coating apparatuses can be lined up. Moreover, the coating apparatuses lined up may have different lengths. For instance, if there are three coating apparatuses according to embodiments described herein arranged with each coating apparatus adapted for performing a different coating process, it is possible that some of the coating process require only a short coating distance whereas other coating processes require a long coating distance. These requirements may particularly arise in the production of solar cells where layers of different properties, in particular of different donations, have to be deposited on the web. The term "coating distance" in this context refers to the length of the endless belt being in contact with the web. Along this distance the web may be coated by the process source while it is held at a predetermined temperature and potential.

A typical method for producing a thin-film solar cell comprises depositing a back contact on the web, depositing an absorbing layer such as amorphous silicon or the like, and depositing a transparent and conductive oxide layer (TCO). Each depositing can comprise several sub steps. For instance, the deposition of amorphous silicon has to follow a predetermined sequence of positively doped, negatively doped, and intrinsic (non-doped) silicon layers. Dependent on the design of the solar cell, the solar cell may comprise several negatively doped layers and/or several positively doped layers and/or several intrinsic layers. Embodiments described herein can be particularly advantageous in the production of thin-film solar cells since the respective coating apparatuses necessary for the desired sequence of deposited layer can be arranged one after the other. Thereby, it is also possible that the web moving directions of the various coating apparatuses is not identical as shown in Figs. 3a-3c but at another angle such as 180°. It is generally also possible that a first process source is arranged at one side of the endless belt whereas a second process source is arranged at the other side of the endless belt. In this event, the web is guided not only be one side of the endless belt but by both sides, i.e. it moves along the one side of the endless belt thereby being exposed to the first process source and it continues moving along the other side of the endless belt being exposed to the second process source.

It is further typical in the production of a solar cell to coat the TCO layer with a protective layer. The typical coating process for the back contact is sputtering. The typical coating process for coating the absorbing layer that is typically made of amorphous silicon is a chemical vapor deposition (CVD) or plasma enhanced chemical vapor deposition (PECVD) process. The typical coating process for coating the TCO layer is sputtering. In general, CVD is typically accomplished under a pressure in the range of between 1 mbar and 100 mbar. Sputtering is typically accomplished under a pressure of between 10⁻² mbar and 10⁻⁴ mbar. Typically, in order to separate the atmospheres of the coating apparatuses from each other, in particular in order to separate the chambers having the coating apparatuses from each other, it is typical to provide seals between the respective chambers.

The plurality of coating apparatuses may provide different process conditions. Having different process conditions, like a different pressure in the vacuum chamber or the use of different coating techniques and/or coating materials, the coating apparatuses may be separated by walls or by chambers, for instance, each coating apparatus being positioned in a separate vacuum chamber. The vacuum chambers may be separated from each other by seals that the web moves through. The expression "the coating apparatus comprises a vacuum chamber" as used herein shall be understood in that the coating apparatus is placed within the vacuum chamber.

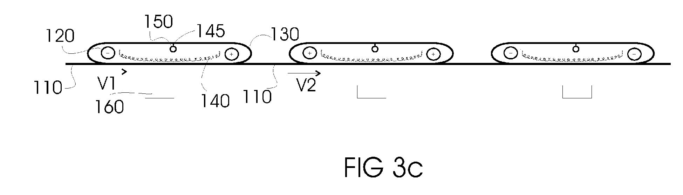

In figure 3b and 3c the same arrangement as in figure 3a is shown but the temperature control means 140 are those according to figures 1b and 1c. The arrangement of three coating apparatuses is an example and does not limit the number of lined up coating apparatuses. For instance, the number of coating apparatuses may be two, or larger than three such as five or ten. Typically, the total length of the process chain can be up to 20 m, 50 m or even 100 m.

As shown exemplarily with respect to the embodiment of Fig. 3b, the coating apparatus may be positioned within a vacuum chamber 300. Typically, the vacuum chamber comprises a vacuum pump (not shown) for drawing off the air from the vacuum chamber. Alternatively, the vacuum chamber may be linked e.g. by a pipe or tube (not shown) to a vacuum chamber for generating the vacuum. In the event of several coating apparatuses each positioned in a different vacuum chamber, the vacuum chambers may have common walls. According to typical embodiments, seals 310 are positioned at the web inlet and web outlet of each chamber. It is possible that the seal at the web outlet of a first chamber acts also as a seal at the web inlet of a consecutive chamber. It shall be emphasized that the provision of vacuum chambers and seals as exemplarily described with regard to fig. 3b is also possible in all other embodiments described herein.

According to embodiments described herein, the coating apparatus can be arranged in many directions. For instance, in figure 1a, 1b and 1c, the coating apparatus is shown in a horizontal arrangement, that is, the web is guided beneath or above the contact side of the endless belt. The coating apparatus may also be arranged in a vertical manner with the web's surface being arranged vertically. Generally, the endless belt could be arranged such that the web's surface is oriented between the horizontal and vertical plane. The web in figure 1a, 1b and 1c is moved beneath the endless belt. But it is also possible that the web is guided above of the endless belt.

In general, the endless belt according to embodiments described herein allows guiding a web over a long distance of at least 3 m, more typically of at least 5 m or 10 m. Hence, the length where the web contacts the endless belt of the coating apparatus according to embodiments described herein can be at least 3 m, more typically at least 5 m or even 10 m and more. In comparison to a drum as known in the art, the guiding device of the embodiments described herein consumes essentially less room, in particular in the dimension perpendicular to the moving direction of the web.

Due to the arrangement described above with reference to figures 3a, 3b and 3c, the allover length of the arrangement can be a multiple of at least 3 m, more typically of at least 5 m or 10 m.

In general, according to different embodiments which can be combined with any of the embodiments described herein, the moving speed of the web in operation of the guiding device is between 0.1 m/min and 15 m/min, more typically between 1 m/min and 10 m/min, even more typically between 1 m/min and 5 m/min.

According to another aspect, a method is provided for depositing an coating material on a web by guiding the web, contacting the web thermally, contacting the web electrically, and coating the web The endless belt itself is guided by an endless belt guiding devices that may comprise two cylinders temporarily contacting the endless belt. The guiding devices may comprise a gear or the like. Typically, at least two guiding devices are provided. According to other embodiments, three, four, five, or more guiding devices are provided. Typically, the method is used for coating a web with a coating material such as evaporating material or sputtering material.

According to embodiments, guiding the web, contacting the web thermally, contacting the web electrically, and coating the web is carried out continuously. "Continuously" shall refer to an operational mode of the coating apparatus where the complete web is coated. In other words, according to typical method embodiments, the endless belt and the coating is not stopped until the web is used up or an error occurs. Typical web lengths are in the range of 100 m to 10 km, more typically between 500 m and 5 km, even more typical between 1 km and 3 km.

According to embodiments described herein, the web is in close contact with the endless belt. This contact is performed e.g. by the tension of the web or by gravity. Therefore it is possible to perform a heat exchange between the endless belt and the web. The heat exchange can be performed by using a temperature control means. Using channels, either the temperature of the web is increased by the thermal energy of the fluid that is contained in the channels, or the temperature of the web is decreased due to the higher temperature of the web compared to the temperature of the fluid transported within the channels. Thereby, the temperature of the web can be brought to a predetermined temperature level or the temperature of the web can be held on a constant temperature level.

According to embodiments described herein, the temperature control means may also be a heating helix or the like. Typically, the temperature of the web to be coated is held constant on a predetermined level in order to ameliorate the quality of the coating process.

According to embodiments described herein, the endless belt is connected to an electrical source. Therefore, a charging of the endless belt is possible. As the web contacts the endless belt, the electrical potential of the endless belt can be adapted to the electrical potential of the web. The charging of the web is useful for several coating methods. In some embodiments, the electrical charging of the web by the process of coating may not be desirable. The endless belt with the connection to the electrical source may act as a counter electrode transmitting the charge to the electrical source.

According to embodiments described herein, the web is guided by the endless belt. Due to the contact of the web with the endless belt, the web is moved with the same velocity as the belt itself. Moreover, the direction of movement of the web can be changed by changing the direction of the movement of the belt. According to some embodiments described herein, the endless belt is only driven by the movement of the web.

According to embodiments described herein a method for evaporating a coating material on a web is provided comprising the step of keeping the web at a predetermined temperature and keeping the web at a predetermined potential.

A system is provided comprising a coating apparatus for depositing a coating material on a web. The system includes a device for guiding and contacting the web. The device comprises an endless belt. The web contacts the endless belt during the process of coating. With the contact, it is possible to bring or maintain the web to or on a predetermined temperature. Instead of cooling or heating the web directly, the contact to the endless belt is used in order to perform heat exchange. Close to the endless belt, a temperature control means is located. The term "close" in this context refers to a distance that is typically less than 10 cm and more typically less than 5 cm.

According to embodiments described herein, the temperature control means can be made of fluid-filled channels or the like. The contact between the belt and the web is capable to transmit energy. This may be for instance electrical energy.

According to embodiments described herein, the web is moved by contacting the moving endless belt. The endless belt serves as a guiding device for the web.

In general, the following embodiments can be combined with any of the embodiments described herein. In general, embodiments described herein are typically applied in one or two of the following two applications:

Firstly, in typical applications of embodiments described herein, a web is coated with a coating material on one side of the web. This side shall be called "coated side" or "front side" of the web. Typically, the web remains uncoated on the other side of the web. This side shall be called "uncoated side" or "rear side" of the web. Depending on the coating, it is desirable not to touch the coated side of the web during coating and web handling such as web guiding, web heating or cooling, and discharging or charging the web.

"Coating" in the context described herein refers, for instance, to sputtering or evaporation techniques allowing to deposit the coating material on the web. When referring to sputtering, the process source shall be synonymously called "sputtering process source" or "sputter etcher". When referring to evaporating, the process source shall be called "evaporator" or "evaporation process source". An exemplary evaporator is a crucible. In general, the process source according to embodiments described herein can be an evaporator or a sputter process source. It is furthermore possible to arrange several coating apparatuses according to embodiments described herein in succession with a part of the coating apparatuses being equipped with a sputter process source and another part of the coating apparatuses being equipped with an evaporation process source. Such an arrangement is particularly typical in the production of thin-film solar cells. According to embodiments described herein, the successive arrangement of several coating apparatuses can be in a row.

In applications where any contact with the uncoated side shall be avoided, the web has to be guided with its coated side always facing away from guiding devices such as rollers, rolls, drum, or the like. However, particularly in coating apparatuses having a long coating distance, such as in the production of thin-film solar cells, it is laborious or even impossible to arrange the web by drums in such a way that its coated side never faces a guiding device. Embodiments described herein allow web guiding, cooling, heating, charging and coating without contacting or touching the coated web side. This is particularly advantageous in the production of thin-film solar cells where it is desirable that the deposited amorphous silicon is not touched or contacted. Hence, according to embodiments described herein, the design of the coating apparatus allows a better contacting for exchanging any sort of energy, such as thermal and electrical energy. Moreover, the embodiments described herein avoid a bending of the coated web if compared to techniques using a drum or a roller.

Secondly, as explained previously, especially in some coating applications such as the coating of positively or negatively doped amorphous silicon it is necessary to provide for a long coating distance. As explained before, due to the resulting size of a drum, it is almost impossible to use a drum for guiding the web for coating distances of about 5 to 10 m and more. Alternatively, so-called "free-span" techniques are known where the web is not guided during passing the coating distance. This technique reveals major problems with respect to the guiding properties and temperature and charging control of the web. Embodiments described herein provide an advantageous alternative to the free-span or drum techniques by guiding the web and allowing controlling the temperature and the electrical charging during the coating process. Furthermore, an arrangement of a plurality of evaporating apparatuses is possible and therefore the length where the web is guided can be extended to a multiple of the length of one coating apparatus.

It is further possible that the endless belt is provided with one ore more intermediate guiding devices arranged between the outermost guiding devices. The intermediate guiding devices are arranged to back the endless belt and are, mathematically spoken, arranged tangentially to the endless belt. In general, the one or more intermediate guiding devices do not alter the moving direction of the endless belt. Hereto in contrast, the outermost guiding devices alter the moving direction at some angle, typically at 180° or below (see figures). The intermediate guiding devices may be useful for guaranteeing a flat endless belt surface that the web is in contact to. This is particularly relevant for long endless belts. Further, the intermediate guiding devices may further allow thermally and electrically contacting the endless belt in order to keep the endless belt at a predetermined temperature and potential.

While the foregoing is directed to embodiments of the invention, other and further embodiments of the invention may be devised without departing from the basic scope thereof, and the scope thereof is determined by the claims that follow.

## Claims

1. Coating apparatus for coating a web (110) with a coating material, the coating apparatus having
• a coating process source (160);
• an endless belt (110) for guiding and contacting the web, the endless belt being at least partly conductive and being equipped with
- a temperature control means (140) for keeping the web at a predetermined temperature; and
- a contact (145) for contacting the endless belt with a power supply (150).

2. Coating apparatus according to claim 1 wherein the process source is an evaporator.

3. Coating apparatus according to claim 2 wherein the evaporator is a heatable crucible for receiving and evaporating the coating material.

4. Coating apparatus according to any of the preceding claims wherein the process source is made of one or more materials selected from the group consisting of a metallic boride, a metallic nitride such as titanium nitride, a metallic carbide, a non-metallic boride, a non-metallic nitride, a non-metallic carbide, nitrides, borides, graphite, B₄C, SiC, TiB₂, a combination of TiB₂ and AlN, a combination of TiB₂ and BN, or a combination of TiB₂, BN and AlN.

5. Coating apparatus according to claim 1 or 2 wherein the process source is a sputter process source.

6. Coating apparatus according to any of the preceding claims wherein the temperature control means comprises channels for receiving a fluid.

7. Coating apparatus according to any of the preceding claims further comprising guiding devices (120) for guiding the endless belt.

8. Coating apparatus according to claim 7 wherein the temperature control means is located in a guiding device.

9. Coating apparatus according to any of the preceding claims wherein the endless belt has a contacting side for contacting the web and a side opposite thereto, wherein the temperature control means is arranged on the opposite side of the endless belt.

10. Coating apparatus according to any of the preceding claims having additional intermediate guiding devices.

11. Coating apparatus according to any of the preceding claims, wherein the contact of the endless belt with the power supply allows an electrical discharging of the web via the endless belt.

12. Coating apparatus according to any of the preceding claims wherein the contact of the endless belt with the power supply allows an electrical charging of the web via the endless belt.

13. Coating apparatus according to any of the preceding claims comprising a vacuum chamber (180) for providing a vacuum atmosphere.

14. Arrangement comprising at least two coating apparatuses according to any of claims 1 to 13.

15. Method for coating a web with an coating material, the method comprising:
• guiding the web;
• contacting the web thermally;
• contacting the web electrically; and
• coating the web with the coating material.

16. Method according to claim 15 wherein the web is coated at one side of the web while it is synchronously guided on the other side of the web.

17. Method according to claim 15 or 16 wherein contacting the web thermally comprises keeping the web at a predetermined temperature.

18. Method according to any of claims 15 to 17 wherein contacting the web electrically comprises keeping the web at a predetermined potential.

19. Method according to any of claims 15-18 wherein one or more of guiding the web, contacting the web thermally, contacting the web electrically, and coating the web is carried out continuously.

20. Method according to any of claims 16 to 19 wherein guiding the web is undertaken by an endless belt with the endless belt being adapted for contacting the web thermally and electrically.

21. Method according to any of claims 16 to 20 wherein a predetermined voltage is applied to the endless belt.
